# EUROPEAN PATENT APPLICATION

(11) **EP 0 735 682 A1**
(43) Date of publication of application: **02.10.1996**
(21) Application number: 95830122.8
(22) Date of filing: 31.03.1995
(51) Int. Cl.: H03K 17/687

(54) **MOS transistor switching circuit without body effect**

(71) Applicant: SGS-THOMSON MICROELECTRONICS S.r.l., I-20041 Agrate Brianza (Milano) (IT)
(72) Inventor: Tomasini, Luciano, I-20052 Monza, (Milano) (IT); Castello, Rinaldo, I-20043 Arcore, (Milano) (IT); Clerici, Giancarlo, I-20059 Vimodrone, (Milano) (IT); Bietti, Ivan, I-46040 Casalromano, (Mantova) (IT)

(57) **Abstract**

Switching circuit with MOS transistors without body effect comprising a first transistor (M1) inserted with source and drain terminals between two connection terminals (S,D) and a second (M2) and a third (M3) transistor inserted in mutual series by means of their respective source and drain terminals between the first transistor (M1) and a ground (GND).

The gate terminal of the second transistor (M2) is connected to the gate terminal of the first transistor (M1) to which is applied a command signal (C) upon switching in phase opposition to that which is applied to the gate terminal of the third transistor (M3).

The substrates of the first and the second transistors (M1,M2) are connected to a connection node (N) between the second and third transistor (M2,M3). The substrate of the third transistor (M3) is connected to ground.

## Description

The present invention relates to integrated circuit switching circuit means and specifically to a switching circuit for an electronic switch for low-voltage power supply circuits integrated with CMOS technology.

Switching circuit means are indispensable in various integrated circuit applications such as for example circuits with switched capacitors for filters with reduced harmonic distortion and wherein electronic switches realized with MOS transistors are piloted by means of distinct timing signals with phases not superimposed.

A rather simple type of electronic switch which is used commonly by one of ordinary skill in the art is the so-called "pass-transistor" consisting of two complementary CMOS transistors which are connected in parallel together with their respective source and drain terminals and are piloted by signals in phase opposition upon switching.

This switch displays no drawbacks in integrated circuits with sufficiently high supply voltage on the order of at least 5V.

But when supply voltage has lower values, typically around 3V, as is the present trend for many integrated circuits, it is necessary to allow for that which in the technical literature is known as body effect where the term "body" represents the actual substrate of a transistor.

Indeed, in any CMOS process of two mutually complementary transistors one is realized in its own substrate termed "well" or pocket.

For example, in a CMOS process defined as the N-well type it is the p-channel transistor which is realized in an independent substrate termed "N-well" and conversely for the P-well type.

As is well known to one of ordinary skill in the art the actual threshold voltage upon conduction of the transistors of a CMOS integrated circuit depends on the body effect, meaning that the actual threshold voltage VTH of a transistor increases in absolute value when the voltage VSB between source and body of the transistor is different from zero, i.e. if the transistor substrate is not short-circuited with its source region. It increases as VSB increases.

Generally, for correct operation of a "pass-transistor" the n-channel transistor substrate is kept at the lowest potential existing in the integrated circuit while that of the p-channel transistor is kept at the highest potential.

If the supply voltage is too low for certain voltages at the two ends of the switch it might be impossible for the body effect to switch to conduction at least one of the two transistors making up the "pass-transistor" and thus permit correct operation of the switch.

As explained in the article 'Higher Sampling Rates in SC Circuits by On-Chip Clock-Voltage Multiplication' by F. Krummenacher, H. Pinier and A. Guillaume - Laboratoire d'electronique général, EPFL, Lausanne, Switzerland, the solution used by one of ordinary skill in the art is to pilot the switch transistors with voltage-boosted signals in phase opposition, i.e. having maximum amplitude in greater voltage (usually double) than that of supply voltage.

There is thus ensured correct operation of the switch even with low supply voltage values. However, this solution involves the shortcoming that it requires a complicated circuit to generate the voltage-boosted piloting signals.

Another solution is to use the so-called "natural" MOS transistors.

As known to one of ordinary skill in the art, their ignition threshold is significantly lower than that of conventional MOS transistors.

But using natural transistors involves additional operations of masking and diffusion of impurities as compared with a conventional integration process with resulting cost increases.

In European patent application no. 94830387.0 of this same applicant filed 29 July 1994 there is described an electronic switch with MOS transistors without body effect and comprising mutually complementary transistors.

The technical problem underlying the present invention is accordingly that of realizing an electronic switch with MOS transistors even not complementary which while preserving circuit simplicity would permit avoiding the shortcomings due to body effect without at the same time increasing manufacturing costs.

This technical problem is solved by a switching circuit of the type indicated above and defined in the characterizing part of the claims which follow this description.

The characteristics and advantages of the switching circuit in accordance with the present invention are set forth in the description of an embodiment thereof given below by way of non-limiting example with reference to the annexed drawings.

In the drawings:

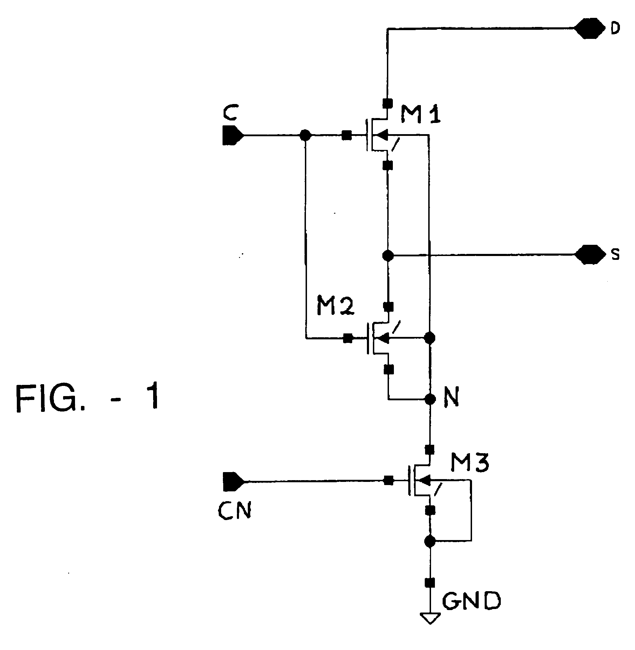

FIGS. 1, 2, 3 and 4 show possible circuit diagrams for an electronic switch in accordance with the present invention usable in integrated circuits with conventional CMOS processes.

FIG. 1 shows the diagram of a switching circuit in accordance with the present invention which permits realization of an electronic switch with MOS transistors without body effect for low-voltage supply voltage integrated circuits.

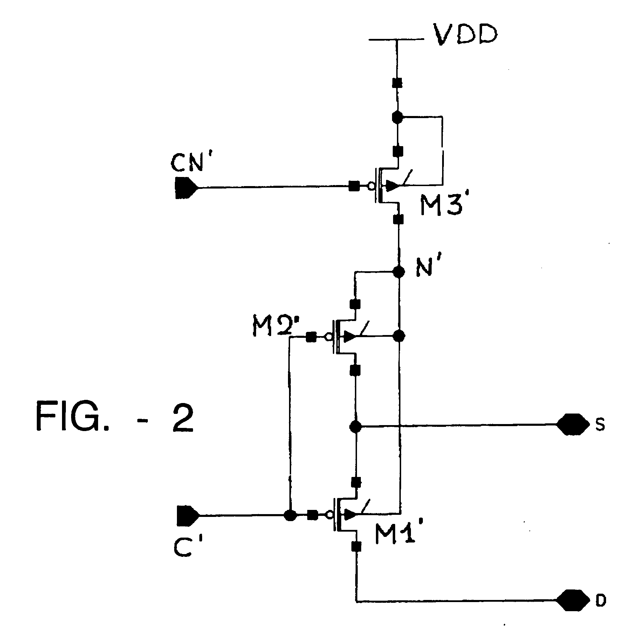

In this diagram are used n-channel transistors while in the equivalent one of FIG. 2 are used p-channel transistors.

A first transistor M1 is inserted with its source and drain terminals between two connection terminals, S and D.

At its gate terminal can be applied a switching command signal.

In accordance with the present invention the circuit diagram of FIG. 1 comprises a second and a third transistors M2 and M3 inserted in mutual series with their respective source and drain terminals between the source terminal of the first transistor M1 and a reference potential which for the diagram of FIG. 1 is a ground GND of the device in which is inserted the electronic switch while for the diagram of FIG. 2 it is power supply pole VDD of the device.

The gate terminal of the transistor M2 is connected to that of the transistor M1 while to the gate terminal of the transistor M3 must be applied a command signal CN in phase opposition to the command signal C.

In accordance with the present invention the substrates or "bulk" of the transistors M1 and M2 are both connected to a circuit node N for connection of the drain terminals of the transistors M2 and M3 while the substrate of the transistor M3 is connected to ground GND.

In the diagram of FIG. 2 the substrates of the transistors M1' and M2' are both connected to a circuit node N' which in this case is a connection node between the source terminal of the transistor M2' and the drain terminal of the transistor M3'.

The substrate of the transistor M3' is then connected to the power supply pole VDD.

Of course the operating conditions distinguish between the source and drain terminals of the MOS transistors.

Considering the circuit diagram of FIG. 1 it can be seen that M1 is the actual switching element while M2 and M3 are auxiliary elements which permit connecting the bulk of the transistor M1 alternatively to ground GND or to the source of this transistor.

The signals C and CN are the voltages applied to the gate terminals of the transistors M1 and M3 and are logical commands, one the "negate" of the other.

When M1 does not conduct with its gate terminal at low-voltage, neither does M2 conduct and is thus is "open" with M1.

In this case the gate voltage of the transistor M3 is high and M3 is thus closed, permitting the bulk of M1 to be connected to ground.

The difference in potential between the bulk and ground is very small.

When the gate voltage of the transistor M1 is high, M1 is closed and so is transistor M2.

In this manner the bulk of the transistor M1 is connected to its own source and thus the difference in potential between the bulk and source is very small.

The body effect is nearly completely eliminated because the gate voltage of transistor M3 is low and M3 thus being open does not permit any connection between the bulk of the transistor M3 and ground GND.

Operation of the switching circuit whose diagram is shown in FIG. 2 is equivalent.

In many cases, especially for differential circuit structures it is recommended to have symmetrical circuits even at the cost of greater integration area occupation.

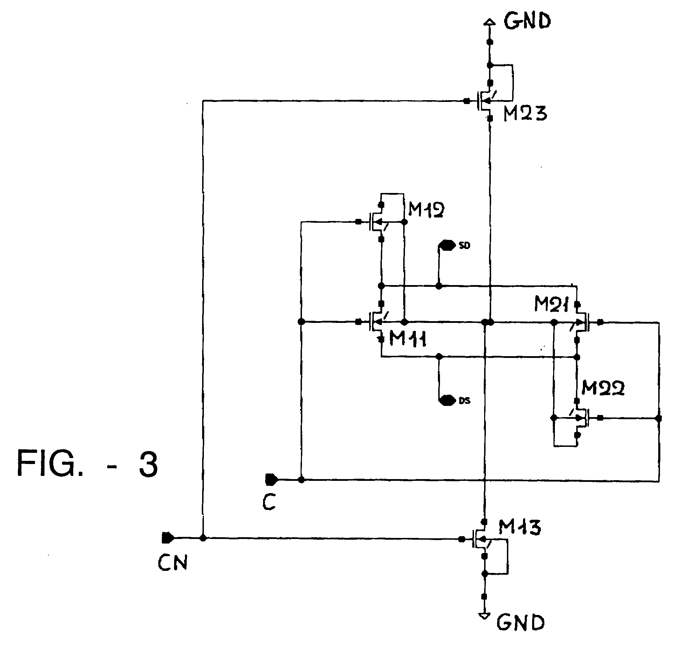

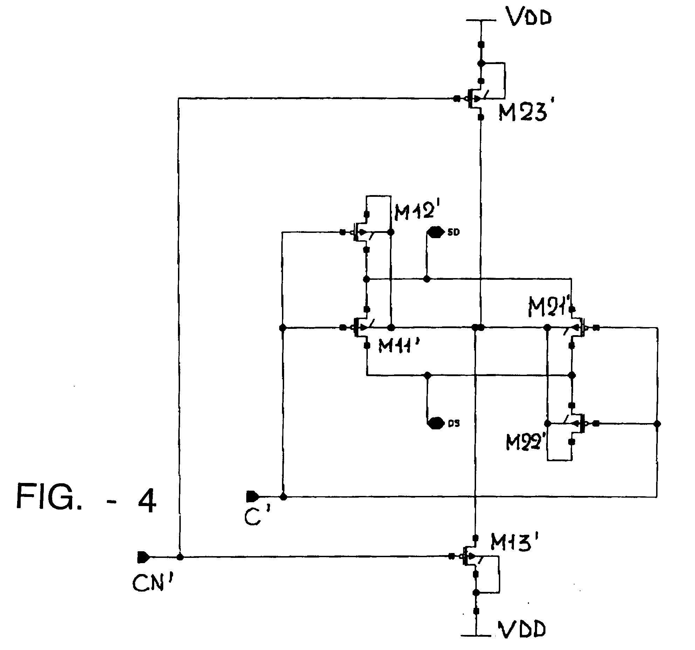

FIGS. 3 and 4 show how to realize electronic switches with n-channel or p-channel MOS transistors by inserting symmetrically between two connection terminals SD and DS a pair of switching circuits of the type indicated in FIG. 1 or FIG. 2.

In these two cases the transistors M11 and M21 and threshold transistors M11' and M21' are piloted by the same command signal. In an equivalent manner but with the same signal in phase opposition are piloted the transistors M13 and M23 and the transistors M13' and M23'.

There can also be united in a complementary configuration to realize a pass-transistor free of body effect a switching circuit in accordance with FIG. 1 and a switching circuit in accordance with FIG. 2.

In this configuration the two main transistors must be piloted in mutual phase opposition and similarly for the auxiliary transistors.

All the circuit solutions now described can adopt in place of the conventional MOS transistors natural MOS transistors. In this manner there can be achieved a further reduction of the thresholds.

Integration, modification and replacement of elements can be made to the embodiments of the present invention in a manner known to one of ordinary skill in the art.

## Claims

1. Switching circuit for a low-voltage power supply device integrated monolithically on a semiconductor plate having a first and a second connection terminal and comprising a first transistor (M1) which has a first, a second and a command terminal and is inserted with said first and second terminals between said first (S) and second connection terminals (D) and characterized in that it includes a second transistor (M2) and a third transistor (M3) each having a first, a second and a command terminal and being inserted in mutual series each by means of its own first and second terminals respectively between the first terminal of the first transistor and a reference potential with the command terminal of the second transistor connected to the command terminal of the first transistor and characterized in that the first and second transistors have substrates connected to a connection circuit node (N) between the second and the third transistors and the third transistor has a substrate connected to the reference potential.

2. Switching circuit in accordance with claim 1 and characterized in that the first, second and third transistors are n-channel MOS transistors and the reference potential is a ground of the device (GND).

3. Switching circuit in accordance with claim 1 and characterized in that the first, second and third transistors are p-channel MOS transistors and the reference potential is a power supply pole (VDD) of the device.

4. Switching circuit in accordance with any one of claims 1, 2 and 3 and characterized in that the first and third transistors are piloted by command signals in mutual phase opposition (C,CN).

5. Switching circuit in accordance with any of claims 1, 2, 3 and 4 and characterized in that the first, second and third transistors are the natural MOS type.

6. Monolithically integrable filter characterized in that it comprises capacitors switched by means of switching circuits in accordance with any of claims 1, 2, 3, 4 and 5.

7. Electronic switch for a low-voltage power supply device integrated monolithically on a semiconductor plate and characterized in that it comprises a first and a second switching circuit both in accordance with claims 1, 2, 3, 4 and 5 with the first connection terminal of the first switching circuit being connected to the second connection terminal of the second switching circuit to constitute a first connection terminal of the switch and the second connection terminal of the first switching circuit being connected to the first connection terminal of the second switching circuit to constitute a second connection terminal of the switch and the command terminals of the first and third transistors of the first switching circuit being connected respectively to the command terminals of the first and third transistors of the second switching circuit.

8. Monolithically integrable filter characterized in that it comprises capacitors switched by means of electronic switches in accordance with claim 7.

9. Switching circuit of the "pass-transistor" type and characterized in that it comprises a switching circuit in accordance with claim 2 and a switching circuit in accordance with claim 3.

10. Monolithically integrable filter characterized in that it comprises capacitors switched by means of switching circuits of the "pass-transistor" type in accordance with claim 9.
